(19)

Europäisches
Patentamt

European
Patent Office

Office européen
des brevets

(11) **EP 2 942 477 A2**

(12) **EUROPEAN PATENT APPLICATION**

(43) Date of publication:
**11.11.2015  Bulletin 2015/46**

(51) Int Cl.:
*E21B 43/00* (2006.01)    *E21B 47/10* (2012.01)

(21) Application number: **15158069.3**

(22) Date of filing: **06.03.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **23.04.2014  GB 201407164**

(71) Applicant: **Petroleum Experts Limited**
**Edinburgh EH7 4HG (GB)**

(72) Inventor: **Guedroudj, Abdelhamid**
**Edinburgh, EH14 1DW (GB)**

(74) Representative: **Hayden, Nicholas Mark**
**Murgitroyd & Company**
**Scotland House**
**165-169 Scotland Street**
**Glasgow G5 8PL (GB)**

(54)    **Method of monitoring a reservoir system using image well technique**

(57)    Disclosed are a method and associated computer apparatus and computer program, for modelling boundary conditions in reservoir models such as multi-dimensional streamline models. The present method is based on the so-called image well technique. The present method solves a flux equation for each of at least one pair of flux points, placed at boundaries delimiting a reservoir region, by varying a flow rate of at least one image well placed around the boundaries to create the boundary conditions along each boundary.

Fig. 5

**Description**

The present invention relates to systems and methods for monitoring a reservoir system using image well technique, and in particular for defining boundary conditions in streamline reservoir simulations.

Streamline methods have been widely used in the petroleum industry by engineers to study the performance and predict the behaviour of oil and gas fields. Streamline based flow simulation models provide fast simulation of large reservoir models (e.g. sweep efficiency and production well fractional flows), without the need of conventional grid based simulators. While streamline models are not a substitute for conventional, elaborate reservoir simulators; the speed, versatility and simple nature of the method allows a quick and accurate analysis of different well patterns and their effect on the total hydrocarbon recovery in oil reservoirs.

The image well method may be used to simulate boundary effects. The boundaries may be either 'no flow' boundaries (representing partitions through which no fluid can flow) or 'fixed (or constant) pressure' boundaries (i.e. the flow through the boundary is sufficient to ensure that the pressure at that point is always constant). However, the image well method presents some disadvantages that make its implementation inadequate in some situations. For example, particular complications are encountered when handling boundary arrangements which comprise one or more pairs of parallel boundaries (as would be the case in a standard rectangular model). Such arrangements theoretically require an image well system extending to infinity. In practice, a system extending to infinity is not possible to implement and, thus, a limited number is typically used. This limited number is still very large and difficult to manage. Additionally, when multiple production and injection wells are being modelled the system can become even more complex and difficult to manage.

It is desirable to model the boundary conditions in a streamline model while reducing model complexity.

**SUMMARY OF INVENTION**

In a first aspect of the invention there is provided a method of monitoring a reservoir system, said method comprising:

   providing a model of said reservoir system comprising representations of at least one real well and a reservoir region;
   placing one or more image wells within said model;
   identifying one or more pairs of points within the model as pairs of flux points; determining a measure of the flux between each identified pair of flux points; calculating the flow rate value required for each of said one or more image wells, using said determined flux between each pair of flux points, so as to create specified boundary conditions for said model; and
   using said calculated flow rate values to create said specified boundary conditions.

Other aspects of the invention comprise a computer program comprising computer readable instructions which, when run on suitable computer apparatus, cause the computer apparatus to perform the method of the first aspect; and an apparatus specifically adapted to carry out all the steps of any of the method of the first aspect.

Other non-essential features of the invention are as claimed in the appended dependent claims.

BRIEF DESCRIPTION OF THE DRAWINGS

Embodiments of the invention will now be described, by way of example only, by reference to the accompanying drawings, in which:

   Figure 1 shows an example model comprising a boundary, a real well and an image well;
   Figure 2 shows an example model comprising two perpendicular boundaries, a real well and image wells;
   Figure 3 shows an example model comprising two parallel boundaries, a real well and image wells;
   Figure 4 shows an example model illustrating an image well system extending to infinity;
   Figure 5 is a flowchart comprising method steps according to an embodiment of the present invention;
   Figure 6 shows an example model obtained according to an embodiment of the present invention; and
   Figure 7 illustrates a modelling step in accordance with an embodiment of the present invention.

**DETAILED DESCRIPTION OF THE EMBODIMENTS**

Described herein are methods for modelling boundary conditions (e.g. 'no flow' and/or 'fixed pressure' boundaries) in multidimensional streamline models. The methods disclosed do not use conventional image well techniques. Furthermore, the present method allows additional wells to be added within a modelled area without requiring any additional changes to be made.

Within the oil industry, the amount of fluid which can be produced from a well is dependent upon the energy which remains within the reservoir. At the start of the life of the field, the pressure (and therefore the energy) of the reservoir is high and hence a lot of fluid can be produced. As fluid is produced, the pressure (i.e. the energy) within the reservoir decreases and this means it is harder to produce more fluid.

To counteract this reduction in pressure it is common to inject water into the reservoir to stop the pressure decreasing. This acts to stabilise the energy which the reservoir contains and therefore allows a higher rate of fluid to be produced.

Injecting water, however, does have a downside. The additional water in the reservoir will be free to flow and therefore it is possible that the injected water will find its way to the production wells, and will be produced with the original reservoir fluid up the well. As the density of water is greater than the density of oil, producing more water from the well makes it harder to lift the fluid to surface and therefore, as the fraction of water in the total produced fluid (known as the water cut) increases, the rate which can be produced from the well decreases.

The objective of water injection therefore becomes a balance between maintaining the reservoir pressure as high as possible (to keep the reservoir energy as high as possible) while minimising the recirculation of water between the injector and production wells. To do this, tools are required which allow the reservoir engineers to assess where the water being injected is travelling within the reservoir. If this is understood, then the injection rates of different wells can be adjusted to hold back the breakthrough of water into the production wells and reduce the increase of this water cut over time.

One such tool which can be used for calculating which water injector is supporting which producer is Streamlines. The use of Streamline models within a field management system allows the production and injection history of the system to be kept up to date and sensitivities and calculations to be performed to find the impact of injecting different rates of water into different locations. This information can be analysed and passed back to the field as guidelines which will provide information on which wells the water should be injected into, in order to help maintain the reservoir pressure without recycling the water back to the production wells.

Streamline models provide fast simulation of large reservoir models without the need to build more elaborate 3D numerical simulations. Streamline models calculate the potential field within the reservoir (based upon a series of production and injection wells) for a set of boundary conditions based upon the diffusivity equation. A streamline, which is a velocity vector within the model, is equal to the derivative of the potential with respect to distance. Each streamline begins at an injection well (or an aquifer boundary) and terminates at a production well.

By way of example, consider a well placed within a 2D area (top view). This well will be surrounded by a potential field, with the potential increasing in magnitude as the distance from the well increases. In the absence of any interference, this potential field will extend to infinity, although after a certain distance the change in potential is so small it can be considered to have stopped changing.

In order to accurately calculate the potential field within the reservoir, the calculation should include the effects of the reservoir boundaries on the field. These boundaries come in two main types:

- 'no flow' boundaries (e.g. physical barriers such as shale which do not allow any flow to pass); and
- 'fixed pressure' boundaries (e.g. aquifers which provide energy to the reservoir and keep the pressure at the boundary relatively constant).

The modelling of boundaries in streamline models is routinely achieved using so-called image wells (or the image well method). Image wells are additional 'ghost' or 'virtual' wells (i.e. they do not exist in physical reality), which are placed within a model to fulfil the boundary conditions. However, in physical reality the presence of barriers (represented as boundaries within the model) means that the potential field (and therefore the fluid velocity) would come to an end.

In order to model the boundaries, the image well premise works like a mirror, in that an exact replica of the real well (for a no flow boundary) or a similar well of opposite type to the real well (for a fixed pressure boundary) is placed equidistant from, and on the opposite side of, the boundary, relative to the real well and such that both wells are on a common line which is perpendicular to the boundary.

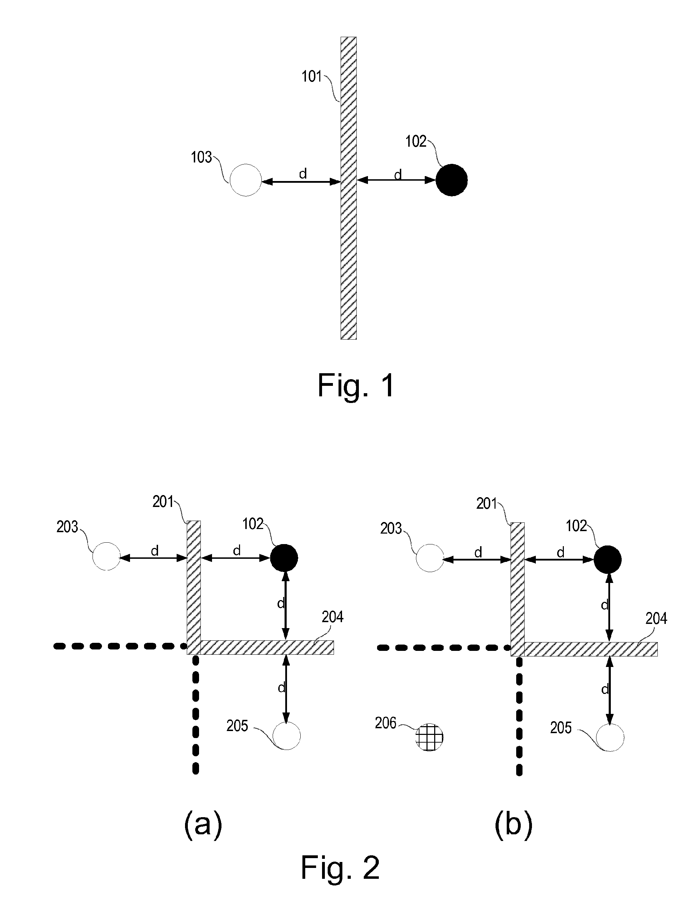

Figure 1 illustrates an example of such an arrangement. Shown is a boundary (or barrier) 101, a real well 102 and an image well 103. The image well 103 is placed at the same distance d from boundary 101 as that of the real well 102, but on the opposite side of boundary 101 (i.e. like a 'mirror' image). The image well in this example represents an exact replica of the real well 102. In this example, any fluid on the left hand side of barrier 101 will move left towards the image well 103, while any fluid on the right hand side of boundary 101 will move towards the real well 102. Therefore, as no fluid can cross barrier 101, boundary 101 represents an effective no flow boundary.

A similar approach can be used to model 'fixed pressure' boundaries. In this case, the image well comprises an "opposite" image well. For example, in presence of a real production (discharging) well, the image well will be of an injection (recharging) well type and *vice versa,* so as to maintain the pressure at the boundary.

The potential P(R,t) of any point of interest, derived from the diffusivity equation for radial flow, is given by equation (1):

$$P(R,t) = P_i + \sum \left( \frac{\mu Q_i}{4\pi kh} Ei\left( \frac{-\emptyset \mu R_i^2}{4kt} \right) \right) \qquad (1),$$

where i is the index for each well (real and image), $Q_i$ is the well production rate of a well at an initial potential Pi, $R_i$ is the distance from each well to the point of interest, *k* is the permeability, $\mu$ is the viscosity , $\Phi$ is the porosity (dimensionless), h is the well height (or more correctly, the height of the formation which in turn is assumed to be the height of the well), *t* is a time interval and *Ei* represents the exponential integral.

As can be seen from equation (1), as each well 102, 103 is approached (i.e. the radius R is getting smaller) the potential, and therefore the pressure drop increases, resulting in a lower pressure. For a 2D system (like the example shown here) all the points are assumed at the same height and therefore pressure and potential can be considered to be the same. The maximum pressure, therefore, is found at the centre point between the two wells 102 and 103 (i.e. boundary 101), with the pressure decreasing either side. Consequently, the velocity (the derivative of the potential) at the centre point will be zero and hence a 'no flow' boundary 101 is created.

Figure 2(a) shows a further example comprising two perpendicular 'no flow' boundaries 201, 204, a real well 102 and two image wells 203, 205 each representing an exact replica of real well 102. Image wells 203, 205 are placed on the opposite side of each boundary 201, 204 relative to real well 102, in a similar manner as in the example of Figure 1. However, this causes an issue as the image well 203, to the left of the real well 102, is also now above the lower no flow boundary 204. This means that there are two wells 102, 203 acting on boundary 204 from above and only one well 205 acting from below. The impact of wells 102, 203, 205 on boundary 204 can no longer be said to balance, thus, the conditions at boundary 204 cannot be considered 'no flow'. The same issue also applies to boundary 201, which has two wells 102, 205 to its right and only one well 203 to its left.

To counter this issue, an additional image well 206 (also a replica of real well 102) is added in the bottom left corner; as shown in Figure 2(b). The presence of image well 206 acts to balance the impact of image wells 203, 205 on boundaries 201, 204 and, therefore, both can now be considered to be 'no flow' boundaries. The example of Figure 2 demonstrates that all wells will have an impact on each other (and on the boundaries). Therefore, additional wells cannot be placed in a model to meet a condition without also considering the impact that these additional wells will have on other conditions and boundaries present in the model.

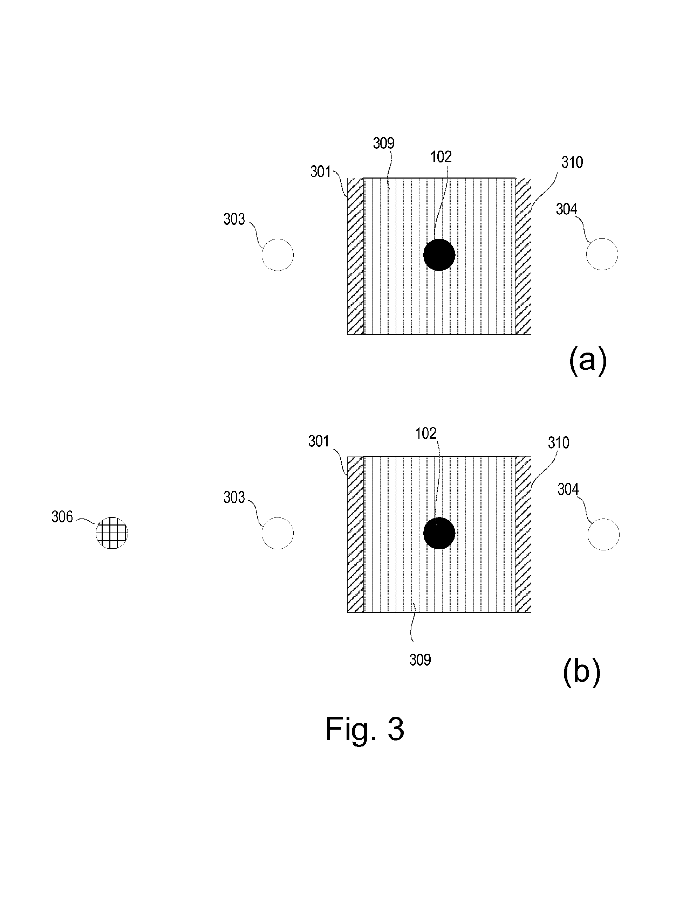

Figures 3(a) and (b) illustrate the problem encountered with parallel boundaries. It shows an example model comprising two parallel boundaries 301, 310, a real well 102, a reservoir region 309 and image wells 304, 303, 306 (each of which is a replica of real well 102). In Figure 3(a), an image well 304 is placed on the opposite side of boundary 310 relative to real well 102. Also an image well 303 is placed on the opposite side of boundary 301 relative to real well 102. However, image well 304 affects the potential field at boundary 310 and also acts on the potential field at boundary 301, which is parallel to boundary 310. This creates an imbalance at boundary 301, which has one well 303 on one side of it and two wells 102, 304 on the other side. Similarly, boundary 310 also has one well 304 on one side of it and two wells 102, 303 on the other side.

In Figure 3(b) a further image well 306 is added to attempt to correct the imbalance around boundary 301. However, this exacerbates the imbalance on the parallel boundary 310. Any attempt to correct for this by adding further wells to the right of well 304 reintroduces the imbalance around boundary 301. The consequence of this is that, when using traditional image well techniques to create boundary conditions and there are two parallel boundaries in a model, the image well system required to balance each boundary must extend to infinity in order to balance both boundaries.

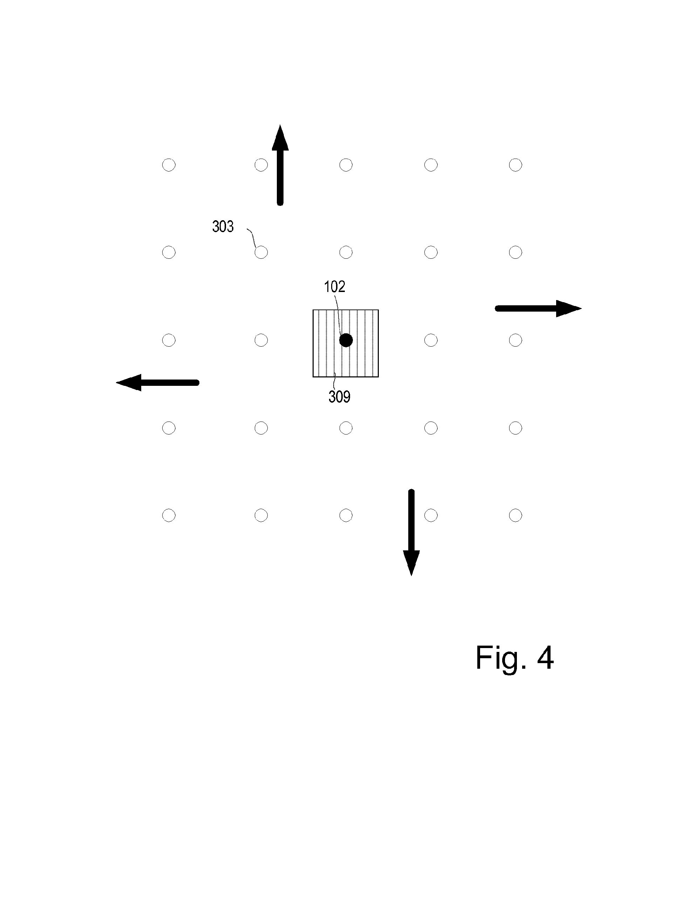

Figure 4 illustrates a reservoir model for streamline calculations, where the reservoir region 309 comprising well 102 is completely bounded on all four sides by boundaries which define the reservoir region 309. The reservoir region 309 shown is rectangular and therefore comprises two pairs of parallel boundaries. To meet the boundary conditions at each of the reservoir region boundaries, image wells 303 are added to the system, which extend to infinity in all directions. In practice, an image well system cannot extend to infinity and will extend until the influence of a new pair of image wells has a negligible effect on the boundaries. This may require a very large and unwieldy number of wells in place, and will be further complicated when multiple real wells are present within the system, each of which will require an image well system which extends to infinity.

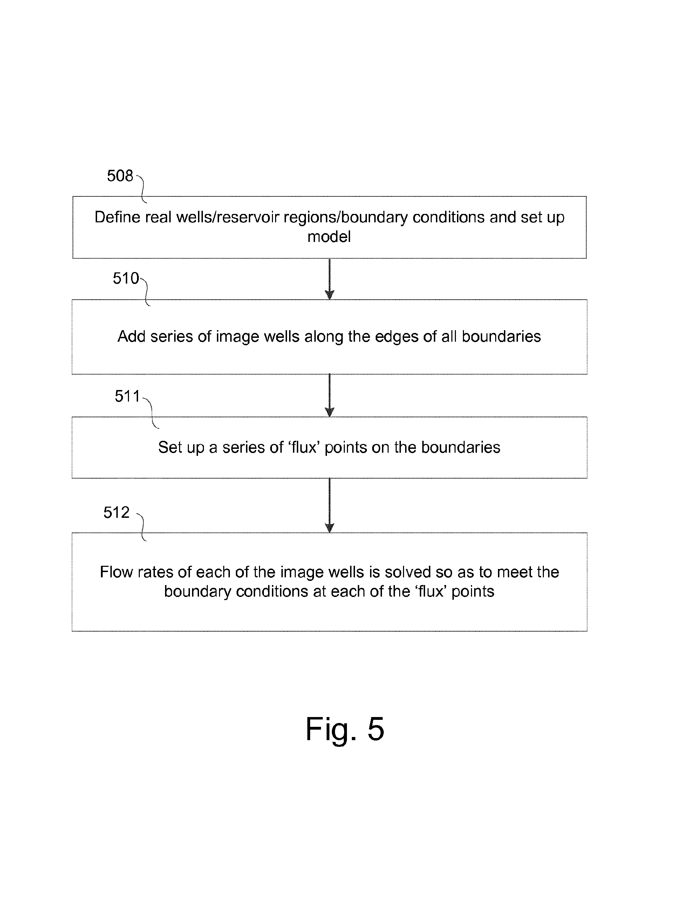

Figure 5 is a flowchart describing a method which addresses the abovementioned issues. It describes a novel, numerically stable method of using image wells to model the boundary conditions in reservoir simulations (e.g. multidimensional streamline models).

At step 508, a system (or model) is defined which comprises the real well(s), reservoir region and boundary conditions. At step 510, instead of placing image wells as identical 'mirror' wells at each defined boundary, series of image wells are placed along the edge of each boundary, such that they largely surround the reservoir region.

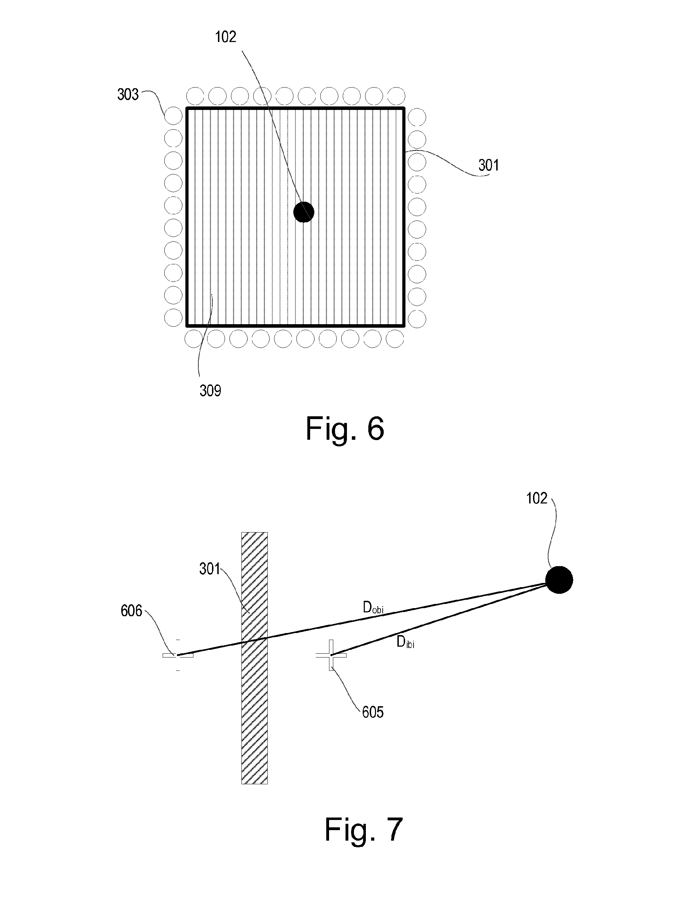

Figure 6 illustrates the model following step 510. The image wells 303 have been placed around the boundaries 301 delimiting a reservoir region 309 comprising real well 102.

At step 511, the model sets up a series of 'flux points' on the boundaries 301. Flux points may be set up such that pairs of flux points are positioned equidistantly relative to the boundary, with one of each pair either side of the boundary and each pair lying on a common line perpendicular to the boundary (i.e. each pair of flux points is positioned symmetrically around the boundary).

At step 512, the flow rates for each of the image wells are calculated so that the conditions at the flux points meet the boundary conditions, thereby creating the boundary conditions along each boundary. For example, this could be either a 'zero' rate at the flux points for 'no flow' boundary conditions or a certain, fixed potential for 'fixed pressure' boundary conditions. Once the boundaries are established in a model, standard industry methods can be used to calculate streamlines from a resulting pressure/rate field.

The equations used by the present method are exactly the same as in the image well method described above (e.g. the diffusivity equation). As mentioned, the present method differs from conventional image well technique in that the rate of each image well is changed so that the boundary condition at each of the flux points is met. This is done by forming a set of simultaneous equations with $Q_i$ (the rate of each image well) as a variable parameter.

Figure 7 illustrates the use of flux points in the method described in Figure 5. It shows a real well 102 placed at a certain distance from a boundary 301. A pair of flux points, comprising a first flux point 605 (inside the boundary) and a second flux point 606 (outside the boundary), is defined (symmetrically) at either side of this boundary.

A well (either real or virtual), whether producing or injecting, affects points 605, 606. The influence of this well on flux point 605 and flux point 606 is proportional to:

$$(Q * \log D^2) \qquad (2).$$

where Q is the production/injection rate of each well and D is the distance from the well to the flux point.

The flux F between flux point 605 and flux point 606 is the difference between these two potentials:

$$F = Q_i \log(D_{ibi}^2) - Q_i \log(D_{obi}^2) = Q_i \log\left(\frac{D_{ib}^2}{D_{ob}^2}\right) \qquad (3),$$

where Qi is the rate of a particular well, $D_{ibi}$ is the distance between that well and (inside boundary) flux point 605 and $D_{obi}$ is the distance between that well and (outside boundary) flux point 606.

By way of example, when modelling a 'no flow' boundary, the flux between these two flux points 605, 606 needs to equal zero (as no flux means no velocity). Therefore, for each flux point pair, the sum of the flux contributions resultant from each of the real and image wells within the system must equal zero, for example:

$$0 = Q_1 \log\left(\frac{D_{ib1}^2}{D_{ob1}^2}\right) + Q_2 \log\left(\frac{D_{ib2}^2}{D_{ob2}^2}\right) + Q_3 \log\left(\frac{D_{ib3}^2}{D_{ob3}^2}\right) + \cdots + Q_i \log\left(\frac{D_{ibi}^2}{D_{obi}^2}\right) \qquad (4)$$

Equation 4 can be rearranged, with one side corresponding to a total flux due to all of the real wells and the other side to the total flux due to all of the image wells. Bringing the resulting equations for each flux point pair together forms a series of simultaneous equations which can be solved by varying the flow rates of each image well ($Q_i$).

A very similar treatment is used for modelling fixed pressure boundaries, the only difference is that the flux between each flux point pair is not set to zero, but rather to an appropriate value calculated so that the potential (and therefore the pressure) at this point matches the given fixed value.

Therefore, the present method models the boundary conditions without the need for an infinite (or very large) image well system. In addition, it is now possible to introduce to, or remove real wells from, the well model without having to adjust the model by adding or removing image wells, as would be the case with conventional techniques. Instead, all that is required is to recalculate the flow rates for each of the image wells, as already described.

One or more steps of the methods and concepts described herein may be embodied in the form of computer readable instructions for running on suitable computer apparatus, or in the form of a computer system comprising at least a storage means for storing program instructions embodying the concepts described herein and a processing unit for performing the instructions. As is conventional, the storage means may comprise a computer memory (of any sort), and/or disk drive or similar. Such a computer system may also comprise a display unit and one or more input/output devices.

The concepts described herein find utility in all aspects of surveillance, monitoring, optimisation and prediction of hydrocarbon reservoir and well systems, and may aid in, and form part of, methods for extracting hydrocarbons from such hydrocarbon reservoir and well systems.

It should be appreciated that the above description is for illustration only and other embodiments and variations may be envisaged without departing from the spirit and scope of the invention.

## Claims

1. A method of monitoring a reservoir system, said method comprising:

   providing a model of said reservoir system comprising representations of at least one real well and a reservoir region;
   placing one or more image wells within said model;
   identifying one or more pairs of points within the model as pairs of flux points;
   determining a measure of the flux between each identified pair of flux points;
   calculating the flow rate value required for each of said one or more image wells, using said determined flux between each pair of flux points, so as to create specified boundary conditions for said model; and
   using said calculated flow rate values to create said specified boundary conditions.

2. A method as claimed in claim 1 wherein a plurality of said image wells are placed along the boundaries defining said reservoir region.

3. A method as claimed in claim 2 wherein said plurality of said image wells comprises plural 1 dimensional arrays of said image wells, each one dimensional array being placed along the full length of each of said boundaries defining said reservoir region.

4. A method as claimed in any preceding claim wherein said pairs of flux points are placed adjacent the boundaries of said reservoir region, one of each pair being placed either side of its adjacent boundary.

5. A method as claimed in claim 4 wherein each pair of flux points are positioned to lie on a common line perpendicular to its adjacent boundary and such that the flux points of each of said pairs of flux points are positioned equidistantly relative to said adjacent boundary.

6. A method as claimed in claim 4 or 5 wherein the flux between each pair of flux points is calculated as the sum of the fluxes between each pair of flux points attributable to each real well and each image well comprised within the model.

7. A method as claimed in claim 6 comprising the steps of deriving a flux equation describing said sum of the fluxes, arranging said equation such that one side of the flux equation corresponds to flux(es) due to said real well(s) and the other side of the flux equation corresponds to flux(es) due to said image well(s).

8. A method as claimed in claim 7 wherein multiple flux equations are derived, one for each pair of flux points, said multiple flux equations being simultaneously solved for the flow rate value(s) of said image well(s) required to create said specified boundary conditions.

9. A method as claimed in any preceding claim wherein said reservoir region comprises one or more pairs of parallel boundaries.

10. A method as claimed in any preceding claim wherein said specified boundary conditions comprise no flow boundaries through which there is no fluid flow, and/or fixed pressure boundaries which impart a substantially fixed pressure onto the reservoir region.

11. A method as claimed in any preceding claim comprising the steps of subsequently adding one or more additional representations of real wells to said model and recalculating for the amended model, the flow rate value(s) of said image well(s) required to create said specified boundary conditions.

**12.** A method as claimed in any preceding claim wherein said model is a streamline model.

**13.** A method as claimed in any preceding claim comprising using the model to calculate the potential field within said reservoir system.

**14.** A method as claimed in any preceding claim comprising using the model in said monitoring of a reservoir system.

**15.** A computer program product comprising computer readable instructions which, when run on suitable computer apparatus, cause the computer apparatus to perform the method of any preceding claim.

Fig. 1

(a)　　　　　　　　(b)

Fig. 2

Fig. 3

Fig. 4

508

Define real wells/reservoir regions/boundary conditions and set up model

510

Add series of image wells along the edges of all boundaries

511

Set up a series of 'flux' points on the boundaries

512

Flow rates of each of the image wells is solved so as to meet the boundary conditions at each of the 'flux' points

Fig. 5

Fig. 6

Fig. 7